# EUROPÄISCHE PATENTSCHRIFT

(11) **EP 1 235 474 B1**
(45) Veröffentlichungstag und Bekanntmachung des Hinweises auf die Patenterteilung: **02.11.2005**
(21) Anmeldenummer: 01104310.6
(22) Anmeldetag: 22.02.2001
(51) Int. Cl.: H05K 13/08, H05K 13/04

(54) **Vorrichtung und Verfahren zur Montage von Bauteilen**
System and method for mounting components
Dispositif et méthode de montage de composants

(43) Veröffentlichungstag der Anmeldung: 28.08.2002
(73) Patentinhaber: Micromont Entwicklungs- und Handels GmbH, 8010 Graz (AT)
(72) Erfinder: Feraric, Johann Peter, Dr., 85579 Neubiberg (DE); Schreiner, Frank, Dr., 81667 München (DE); Mausamer, Tobias, 82008 Unterhaching (DE); Müller, Thomas, 82024 Taufkirchen (DE)
(74) Vertreter: Hofstetter, Alfons J.

(56) Entgegenhaltungen:
- JP-A- 6 085 499
- US-A- 5 249 356
- US-A- 6 101 709

## Beschreibung

Die vorliegende Erfindung betrifft eine Vorrichtung zur Montage von Bauteilen, insbesondere eine vollautomatische Montagevorrichtung zur Herstellung mikrosystemtechnischer Produkte sowie für Montageaufgaben in der Halbleiterindustrie, mit einem Montagetisch, mindestens einem Materialtransportsystem zum Transport der mit Bauteilen zu bestückenden Produkte, mindestens einer auf dem Montagetisch angeordneten und parallel zur Bewegungsrichtung (x-Achse) des Materialtransportsystems bewegbaren Bauteiltransporteinheit und mindestens einem Montagekopf mit mindestens einem Transport- und Montagewerkzeug, wobei der Montagekopf an einem senkrecht zur Bewegungsrichtung (y-Achse) der Bauteiltransporteinheit bewegbaren und verfahrbaren ersten Schlitten der Bauteiltransporteinheit angeordnet ist und einer Mess-Station zur Bestimmung der Relativlage eines von dem Transport- und Montagewerkzeug aufgenommenen Bauteils zum Transport- und Montagewerkzeug.

Des weiteren betrifft die vorliegende Erfindung ein Verfahren zur Montage von Bauteilen, insbesondere mit einer vollautomatischen Montagevorrichtung zur Herstellung mikrosystemtechnischer Produkte.

Derartige Montagevorrichtungen und Verfahren zur Montage von Bauteilen im mikrosystemtechnischen Bereich sind zum Beispiel aus der US-A-6 101 709 bekannt. Dabei werden mikrosystemtechnische Bauteile auf Montagevorrichtungen verarbeitet, die mit "Pick and Place"-Bearbeitungsköpfen ausgestattet sind. Dies sind zum Beispiel die bekannten Die-Bonder in der Halbleiterindustrie.

Maschinen zur Montage von Halbleiter- und Mikrosystembauteilen müssen zunehmend höhere Plaziergenauigkeiten der Bauteile in Kombination mit hohen Durchsatzzahlen erreichen, welche mit heutigen Montagemaschinen nicht oder nur zu Lasten des Gesamtdurchsatzes erreicht werden. Treibende Faktoren für diese Anforderung sind zunehmende Miniaturisierung der Bauteile, steigende Bauteilfunktionalität mit dadurch steigender Zahl der externen, insbesondere der elektrischen Anschlüsse sowie funktionsbedingte Präzisionsanforderungen z.B. bei der optoelektronischen Signalübertragung.

Die Präzisionsmontage von Halbleiter- und Mikrosystembauteilen erfordert daher üblicherweise einen zusätzlichen Messprozess zur Bestimmung der Relativlage des Bauteiles an einem Montagewerkzeug. Dieser Messprozess wird mittels einer separaten Mess-Station und auf Basis bildauswertender Verfahren bewerkstelligt. Dabei wird bei bekannten Maschinenlösungen die erforderliche Mess-Station nach der Bauteilaufnahme separat angefahren. Die Mess-Station befindet sich bei diesen bekannten Lösungen nicht auf dem direkten Weg zwischen Bauteilaufnahme- und Bauteilablageposition, so daß ein Umweg in Kauf genommen werden muss, der zu einer Zeitverzögerung des Montageablaufs führt. Zudem wird kurzzeitig über der Mess-Station gestoppt oder die Transportbewegung verzögert, um eine Bildaufnahme anzustoßen. Erst nach Auswertung der Relativlage Bauteil zu Montagewerkzeug wird zur eigentlichen Ablageposition des Bauteils gefahren und die ermittelte Relativlage als Korrekturwert während der Bauteilablage verwendet.

Sowohl das Anfahren der Mess-Station als auch der kurzzeitige Stop über der Mess-Station erfordern nachteiligerweise Zeit, so daß der Gesamtablauf bei der Präzisionsmontage deutlich verlangsamt wird. Die Folgen sind geringe Durchsatzzahlen, wodurch sich hohe Montagekosten für die Bauteile ergeben.

Aus der US-A-5 249 356 ist eine Vorrichtung zur Montage von Bauteilen bekannt, wobei eine Mess-Station an einer Bauteiltransporteinheit angeordnet ist und vor der Montage des Bauteils zeitweise unter ein Montagewerkzeug verfahren wird, so dass mehrmalige Positionsbestimmungen und -korrekturen des an der Bauteiltransporteinheit gehaltenen Bauteils durchgeführt werden können.

Es ist daher Aufgabe der vorliegenden Erfindung, eine gattungsgemäße Vorrichtung zur Montage von Bauteilen und ein gattungsgemäßes Verfahren zur Montage von Bauteilen bereitzustellen, die einen hohen Bauteildurchsatz gewährleisten.

Gelöst wird diese Aufgabe durch eine Vorrichtung zur Montage von Bauteilen und ein gattungsgemäßes Verfahren zur Montage von Bauteilen mit den Merkmalen gemäß den unabhängigen Ansprüchen 1 und 8.

Vorteilhafte Ausgestaltungen sind in den jeweiligen Unteransprüchen beschrieben.

Eine erfindungsgemäße Vorrichtung zur Montage von Bauteilen weist einen Montagetisch, mindestens ein Materialtransportsystem zum Transport der mit Bauteilen zu bestückenden Produkte, mindestens eine auf dem Montagetisch angeordneten und parallel zur Bewegungsrichtung (x-Achse) des Materialtransportsystems bewegbare Bauteiltransporteinheit und mindestens einen Montagekopf mit mindestens einem Transport- und Montagewerkzeug auf, wobei der Montagekopf an einem quer zur Bewegungsrichtung (y-Achse) der Bauteiltransporteinheit bewegbaren und verfahrbaren ersten Schlitten der Bauteiltransporteinheit angeordnet ist. Zudem weist die Vorrichtung eine Mess-Station zur Bestimmung der Relativlage eines von dem Transport- und Montagewerkzeug aufgenommenen Bauteils zum Transport- und Montagewerkzeug auf, wobei die Mess-Station dabei parallel zur Bewegungsrichtung (x-Achse) der Bauteiltransporteinheit verfahrbar ausgebildet ist, derart, daß das Transport- und Montagewerkzeug mit dem aufgenommenen Bauteil zwischen einer Bauteilaufnahmeposition und einer Bauteilablageposition die Mess-Station überfährt. Durch das Mitbewegen und automatische Überfahren des Mess-Station ist einerseits gewährleistet, daß ein separates Anfahren der erforderlichen Mess-Station entfällt. Zudem kann der Bauteiltransport auf direktem Weg zwischen einer Aufnahme- und Ablageposition des Bauteils erfolgen, so daß sich optimale Weg-Zeit-Verhältnisse bei der Präzisionsmontage von Halbleiter- und Mikrosystembauelementen einstellen. Dies führt vorteilhafterweise zu deutlich erhöhten Durchsatzzahlen bei der Montage derartiger Bauteilen bzw. Bauelemente.

Zudem ist die Mess-Station stationär oder verfahrbar an der Bauteiltransporteinheit angeordnet. Dadurch ist gewährleistet, daß die Mess-Stadion automatisch zur Bewegung der Bauteiltransporteinheit synchronisierte Bewegungen ausführt und es immer zu einem Überfahren der Mess-Station durch das Transport- und Montagewerkzeug bewegte Bauteil kommt. Es ist aber auch möglich, daß die Mess-Station auf einem separaten zweiten Schlitten der Bauteiltransporteinheit angeordnet ist, wobei der zweite Schlitten quer zur Bewegungsrichtung (y-Achse) der Bauteiltransporteinheit bewegbar ist. Zudem ist es möglich, daß die Mess-Station verfahrbar auf dem ersten Schlitten der Bauteiltransporteinheit angeordnet ist. Weiterhin ist es erfindungsgemäß möglich, daß die Mess-Station stationär oder verfahrbar auf einer parallel zur Bewegungsrichtung (x-Achse) des Materialtransportsystems bewegbaren separaten Transporteinheit angeordnet ist.

In einer weiteren vorteilhaften Ausgestaltung der Erfindung weist die Mess-Station mindestens ein optisches Meßsystem auf. Optische Meßsysteme haben sich als besonders vorteilhaft bei der Bestimmung von Positionsdaten von Gegenständen, insbesondere von kleindimensionierten Bauteilen, erwiesen. Gemäß einer vorteilhaften Ausführungsform der Erfindung weist das optische Meßsystem mindestens einen Sensorkopf zur Bildaufnahme, mindestens eine Beleuchtungsquelle mit einem daran angeschlossenen Lichtleiter zur kurzzeitigen Bauteilbeleuchtung und mindestens eine Datenverarbeitungsanlage zur digitalen Bildauswertung und Bestimmung der Relativlage des Bauteils auf.

In einer weiteren vorteilhaften Ausgestaltung der Erfindung ist die Beleuchtungsquelle ein Hochgeschwindigkeitsstroboskop. Dadurch ist es vorteilhafterweise möglich, daß eine sehr kurzzeitige Beleuchtung des sich bewegenden Bauteils dessen Bewegungsunschärfe minimiert.

Ein erfindungsgemäßes Verfahren zur Montage von Bauteilen, insbesondere mit einer vollautomatischen Montagevorrichtung zur Herstellung mikrosystemtechnischer Produkte weist folgende Verfahrensschritte auf: (a) Aufnahme von mindestens einem zu transportierenden und montierenden Bauteils mittels eines an einem ersten Schlitten angeordneten Montagekopf mit mindestens einem Transport- und Montagewerkzeug, wobei der erste Schlitten quer zur Bewegungsrichtung (y-Achse) eines Materialtransportsystems verfahrbar ist und an einer parallel zur Bewegungsrichtung (x-Achse) des Materialtransportsystems bewegbaren Bauteiltransporteinheit angeordnet ist; (b) Verfahren des Transport- und Montagewerkzeugs mit dem Bauteil zu einer vorbestimmten Ablage- bzw. Bearbeitungsposition, wobei ein automatisches Überfahren einer Mess-Station zur Bestimmung der Relativlage des von dem Transport- und Montagewerkzeug aufgenommenen Bauteils zum Transport- und Montagewerkzeug erfolgt und die Mess-Station parallel zur Bewegungsrichtung (x-Achse) der Bauteiltransporteinheit verfahrbar ausgebildet ist, wobei die Mess-Station stationär oder verfahrbar an der Bauteiltransporteinheit angeordnet ist ; (c) Erzeugen eines Triggersignals in Abhängigkeit von der y-Position des ersten Schlittens und Aktivierung der Mess-Station mittels des Triggersignals und (d) Übermittlung der durch die Mess-Station ermittelten Positionsdaten an eine Datenverarbeitungsanlage und Berechnung der Relativlage des Bauteils zum Transport- und Montagewerkzeug. Dadurch ist gewährleistet, daß die ausgewertete Relativlage des Bauteils zum Transport- und Montagewerkzeug bzw. zum Montagekopf unmittelbar vor dem Erreichen der Bauteilablage-Position zur Verfügung steht und kann dort für die Ablagekorrektur verwendet werden kann. Da keine Zeitverzögerungen durch den Mess- und Auswertevorgang erfolgen, ist vorteilhafterweise ein deutlich höherer Bauteildurchsatz möglich.

In einer vorteilhaften Ausgestaltung des erfindungsgemäßen Verfahrens ist die Mess-Station ein optisches Meßsystem mit mindestens einem Sensorkopf zur Bildaufnahme, mit mindestens einer Beleuchtungsquelle mit einem daran angeschlossenen Lichtleiter zur kurzzeitigen Bauteilbeleuchtung. Optische Messverfahren und -systeme haben sich als besonders vorteilhaft bei der Bestimmung von Positionsdaten von Gegenständen, insbesondere von kleindimensionierten Bauteilen, erwiesen. Die Beleuchtungsquelle ist vorteilhafterweise ein Hochgeschwindigkeitsstroboskop.

In einer vorteilhaften Ausgestaltung des erfindungsgemäßen Verfahrens werden im Verfahrensschritt c) folgende Zwischenschritte ausgeführt: (c1) Weiterleiten des Triggersignal an das Hochgeschwindigkeitsstroboskop und Auslösen eines Lichtblitzes von wenigen Mikrosekunden; (c2) Einkoppeln des Lichtblitzes über den Lichtleiter in den Sensorkopf, wobei das Licht um 90 Grad umgelenkt und senkrecht auf die Bauteilunterseite projiziert wird; und (c3) gleichzeitige Aktivierung einer CCD-Kamera durch das Triggersignal, so daß eine Belichtung eines CCD-Sensors der CCD-Kamera zeitsynchronisiert zum Lichtblitz erfolgt. Sowohl durch den sehr kurzen Lichtblitz als auch durch die dazu synchronisierte Beleuchtung des CCD-Sensors (beide Vorgänge im Mikrosekundenbereich) wird das Bild des Bauteils quasi "eingefroren", so daß vorteilhafterweise ein scharfes Bild unabhängig von der unverzögerten Transportbewegung des Bauteils entsteht ("on the fly" - Bilderzeugung).

In einer weiteren vorteilhaften Ausgestaltung des erfindungsgemäßen Verfahrens erfolgt eine zeitgleiche Messung der Position des mit dem Bauteil zu bestückenden Produktes, wobei die im Verfahrensschritt (d) berechnete Relativlage des Bauteils zum Transport- und Montagewerkzeug mit der ermittelten Position des Produkts bzw. einer Ablageposition auf dem Produkt verglichen und gegebenenfalls korrigiert wird, so daß eine lagegenaue Ablage des Bauteils auf dem Produkt erfolgt. Dadurch ist eine deutlich höhere Montagepräzision des Bauteils auf dem zu bestückenden Produkt gewährleistet.

In einer weiteren vorteilhaften Ausgestaltung des erfindungsgemäßen Verfahrens wird die absolute Position des zu bestückenden Produkts bzw. die Ablageposition des Bauteils mittels einer in dem Transport- und Montagewerkzeug angeordneten optischen Mess-Station ermittelt. Durch die aktive "online"-Messung der exakten Ablageposition wird die Montagepräzision erfindungsgemäß nochmals deutlich erhöht.

Weitere Einzelheiten, Merkmale und Vorteile der Erfindung ergeben sich aus der folgenden Beschreibung mehrerer zeichnerisch dargestellter Ausführungsbeispiele. Es zeigen:
- Figur 1: eine schematisch in einer Aufsicht dargestellte Teilansicht der erfindungsgemäßen Vorrichtung zur Montage von Bauteilen;
- Figur 2: eine schematisch dargestellte Teilansicht der erfindungsgemäßen Vorrichtung nach Fig. 1;
- Figur 3: eine schematisch dargestellte Ansicht eines optischen Systems der erfindungsgemäßen Vorrichtung zur Montage von Bauteilen;
- Figur 4: eine schematisch dargestellte Ansicht eines Teils des optischen Systems der erfindungsgemäßen Vorrichtung zur Montage von Bauteilen; und
- Figur 5: eine schematisch dargestellte Teilansicht einer weiteren Ausführungsform der erfindungsgemäßen Vorrichtung zur Montage von Bauteilen.

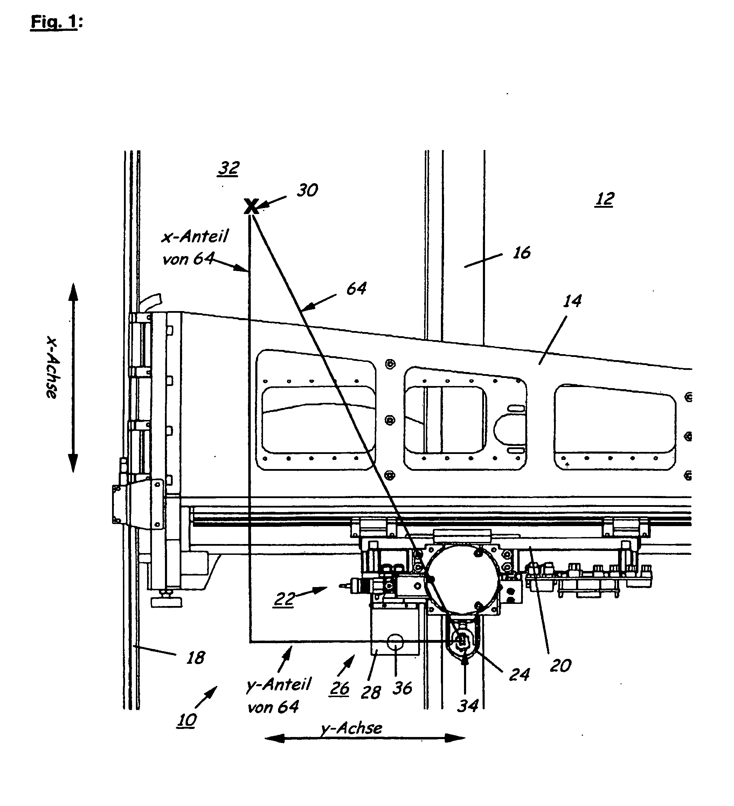

Figur 1 zeigt eine schematisch in einer Aufsicht dargestellte Teilansicht der Vorrichtung 10 zur Montage von Bauteilen. Die Vorrichtung 10 umfaßt einen Montagetisch 12, einen Materialtransportsystem 16 zum Transport der mit Bauteilen zu bestückenden Produkte (nicht dargestellt) und eine auf dem Montagetisch 12 angeordnete und parallel zur Bewegungsrichtung (x-Achse) des Materialtransportsystems 16 bewegbare Bauteiltransporteinheit 14. Die Bauteiltransporteinheit 14 ist dabei portalartig aufgebaut und mittels eines Antriebs (nicht dargestellt) auf einem Schienensystem 18 verfahrbar. Die Bauteiltransporteinheit 14 weist zudem einen Montagekopf 22 mit einem Transport- und Montagewerkzeug 24 auf. Dabei ist der Montagekopf 22 an einem quer zur Bewegungsrichtung (y-Achse) der Bauteiltransporteinheit 14 bewegbaren und verfahrbaren ersten Schlitten 20 angeordnet. Des weiteren erkennt man, daß die Vorrichtung 10 eine Mess-Station 26 zur Bestimmung der Relativlage eines von dem Transport- und Montagewerkzeug 24 aufgenommenen Bauteils zum Transport- und Montagewerkzeug 24 aufweist. Die Mess-Station 26 ist dabei parallel zur Bewegungsrichtung (x-Achse) der Bauteiltransporteinheit 14 verfahrbar ausgebildet, derart, daß das Transport- und Montagewerkzeug 24 mit dem aufgenommenen Bauteil zwischen einer Bauteilaufnahmeposition 30 und einer Bauteilablageposition 34 die Mess-Station 26 überfährt. Das Transport- und Montagewerkzeug 24 bewegt sich dabei auf einem Transportweg 64 von der Aufnahmeposition 30 in einem Bauteilreservoir 32 zu der Bauteilablageposition 34 auf dem zu bestückenden Produkt, welches auf dem Materialtransportsystem 16 befördert wird.

Des weiteren erkennt man gemäß dem in Figur 1 dargestellten ersten Ausführungsbeispiel der Vorrichtung 10, daß die Mess-Station 26 stationär an der Bauteiltransporteinheit 14 angeordnet ist. Dies bedeutet, daß in diesem Fall die Mess-Station 26 ausschließlich eine Bewegung in Richtung der x-Achse ausführt. Es ist aber auch möglich, daß die Mess-Station 26 verfahrbar an der Bauteiltransporteinheit 14 angeordnet ist. Im letzteren Fall würde die Meßstation 26 zusätzlich zu den Bewegungen in Richtung der x-Achse auch Bewegungen in Richtung der y-Achse ausführen. Entsprechendes gilt für die Möglichkeit, daß die Mess-Station 26 verfahrbar auf dem ersten Schlitten 20 der Bauteiltransporteinheit 14 angeordnet ist (nicht dargestellt). Es ist zudem denkbar, daß die Mess-Station 26 stationär oder verfahrbar auf einer parallel zur Bewegungsrichtung (x-Achse) des Materialtransportsystems 16 bewegbaren weiteren Transporteinheit angeordnet ist (nicht dargestellt).

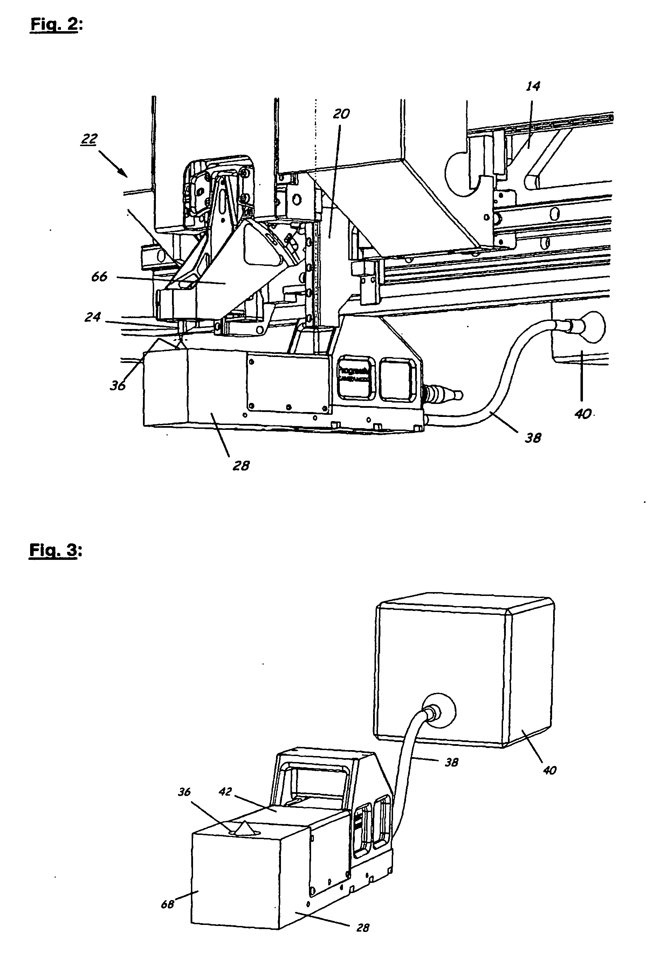

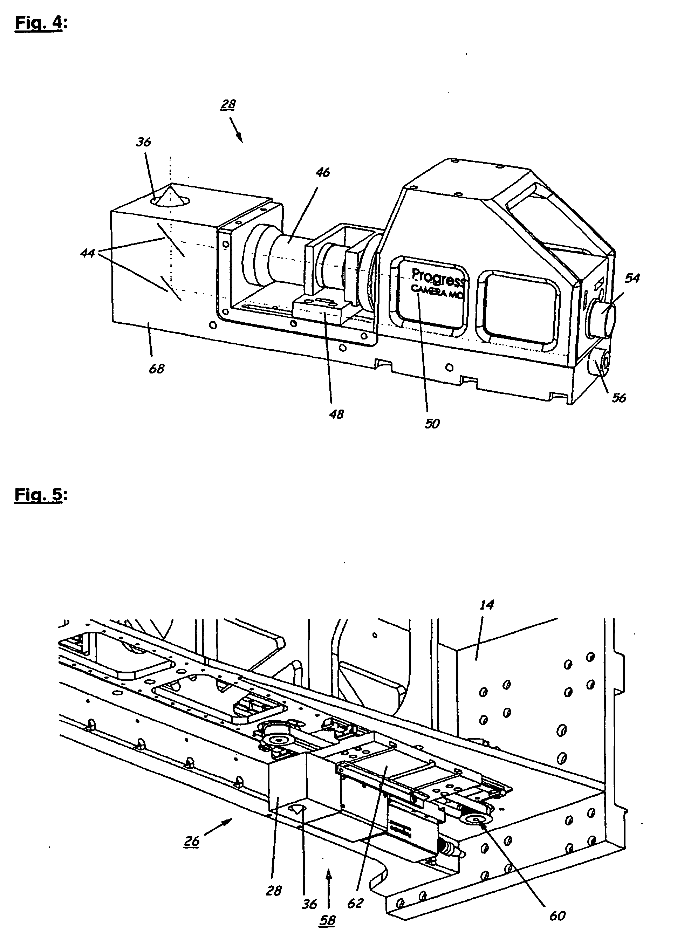

Des weiteren erkennt man, daß die Mess-Station 26 ein optisches Meßsystem aufweist, wobei das optische Meßsystem einen Sensorkopf 28 und eine Austrittsöffnung 36 für einen erzeugten Lichtstrahl aufweist. Eine detaillierte Beschreibung des optischen Meßsystems zeigen die Figuren 3 und 4.

Figur 2 zeigt eine schematisch dargestellte Teilansicht der ersten Ausführungsform der Vorrichtung 10 nach Figur 1. Man erkennt, daß der Montagekopf 22 über einen Montagearm 66 an dem ersten Schlitten 20 der Bauteiltransporteinheit 14 befestigt ist. An dem der Befestigung gegenüberliegenden Ende des Montagearms 66 ist das Transport- und Montagewerkzeug 24 angeordnet.

Des weiteren erkennt man, daß der Sensorkopf 28 des optischen Meßsystems mit der Bauteiltransporteinheit 14 fest verbunden ist. Dabei ist die Austrittsöffnung 36 für einen erzeugten Lichtstrahl derart angeordnet, daß das Transport- und Montagewerkzeug diese Austrittsöffnung 36 überfährt. Der Sensorkopf 28 ist über einen Lichtleiter 38 mit einer Beleuchtungsquelle 40 verbunden.

Figur 3 zeigt eine Detailansicht des optischen Systems der Vorrichtung 10. Man erkennt, daß der Sensorkopf 28 ein Gehäuse 68 aufweist, welches an einem Ende die Austrittsöffnung 36 zeigt. An dem der Austrittsöffnung 36 gegenüberliegenden Ende ist der Sensorkopf 28 über den Lichtleiter 38 mit der Beleuchtungsquelle 40 verbunden. Die Beleuchtungsquelle 40 ist dabei ein Hochgeschwindigkeitsstroboskop. Unter einer Abdeckung 42 des Gehäuses 68 ist die Optik des optischen Systems angeordnet, wie aus Figur 4 erkennbar ist.

Des weiteren ist das optische Meßsystem mit einer Datenverarbeitungsanlage zur digitalen Bildauswertung und Bestimmung der Relativlage des Bauteils über eine entsprechende Datenleitung verbunden (nicht dargestellt).

Figur 4 zeigt eine Detailansicht eines Teils des optischen Systems der Vorrichtung 10. Man erkennt, daß der Sensorkopf 28 aus einer CCD-Kamera 50, einer telezentrischen Makrooptik 46, einem Strahlteilerspiegel 44 zur 90°-Umlenkung des optischen Strahlengangs sowie zur koaxialen Einspiegelung der vom Stroboskop erzeugten Beleuchtung und einem Einstellschlitten 48 zur Adaption des Fokus der CCD-Kamera 50 besteht. An dem der Austrittsöffnung 36 gegenüberliegenden Ende weist der Sensorkopf einen Kameraanschluß 54 und einen Lichtleiteranschluß 56 auf. Über den Kameraanschluß 54 werden u.a. die Bilddaten zur Datenverarbeitungsanlage weitergeleitet.

Figur 5 zeigt eine schematisch dargestellte Teilansicht einer weiteren Ausführungsform der Vorrichtung 10 zur Montage von Bauteilen. Man erkennt, daß die Mess-Station 26 an einem zweiten Schlitten 58 angeordnet ist. Der zweite Schlitten 58 weist dabei einen Antrieb 60 und eine entsprechende Schlittenführung 62 auf. Die Bewegung des zweiten Schlittens 58 erfolgt in Richtung der y-Achse. Zudem ist der zweite Schlitten 58 an der Bauteiltransporteinheit 14 befestigt. Dies bedeutet, daß die Mess-Station 26 nicht nur Bewegungen in Richtung der x-Achse, sondern auch in Richtung der y-Achse ausführen kann. Dadurch ist es grundsätzlich möglich, daß neben der Bestimmung der Relativlage des Bauteils an dem Transport- und Montagewerkzeug 24 auch andere Positionsdaten innerhalb der Vorrichtung 10 durch die Mess-Station 26 ermittelt werden können. U.a. können z.B. mechanische Referenzmarken am Transport- und Montagewerkzeug 24 angebracht sein, die eine digitale Bildauswertung und Bestimmung der Relativlage des Bauteils zum Transport- und Montagewerkzeug 24 ermöglichen.

So kann u.a. auch die Relativlage und Orientierung der einzelnen Bauteilablagepositionen 34 auf dem Produkt relativ zu einer entsprechenden Referenzmarke ermittelt und an die Vorrichtung 10 übermittelt werden. Nach Aufnahme des Bauteils durch das Transport- und Montagewerkzeug 24 wird die Relativlage des Bauteils zum Werkzeug durch die Mess-Station 26 ermittelt und bestimmt. Die ermittelten Positionswerte können dann mit den ermittelten Bauteilablagepositionen verrechnet werden, so daß ggf. entsprechende Korrekturen vorgenommen werden können. Es ist auch möglich, daß die Kontrolle der absoluten Lage der Bauteilablageposition 34 mittels einer in dem Transport- und Montagewerkzeug 24 angeordneten optischen Mess-Station ermittelt und kontrolliert wird (nicht dargestellt).

## Patentansprüche

1. Vorrichtung zur Montage von Bauteilen, insbesondere eine vollautomatische Montagevorrichtung zur Herstellung mikrosystemtechnischer Produkte sowie für Montageaufgaben in der Halbleiterindustrie, mit einem Montagetisch (12), mindestens einem Materialtransportsystem (16) zum Transport der mit Bauteilen zu bestückenden Produkte, mindestens einer auf dem Montagetisch (12) angeordneten und parallel zur Bewegungsrichtung (x-Achse) des Materialtransportsystems (16) bewegbaren Bauteiltransporteinheit (14) und mindestens einem Montagekopf (22) mit mindestens einem Transport- und Montagewerkzeug (24), wobei der Montagekopf (22) an einem quer zur Bewegungsrichtung (y-Achse) der Bauteiltransporteinheit (14) bewegbaren und verfahrbaren ersten Schlitten (20) der Bauteiltransporteinheit (14) angeordnet ist und einer Mess-Station (26) zur Bestimmung der Relativlage eines von dem Transport- und Montagewerkzeug (24) aufgenommenen Bauteils zum Transport- und Montagewerkzeug (24), wobei
die Mess-Station (26) parallel zur Bewegungsrichtung (x-Achse) der Bauteiltransporteinheit (14) verfahrbar ausgebildet ist, wobei die Mess-Station (26) stationär oder verfahrbar an der Bauteiltransporteinheit (14) angeordnet ist, derart, dass das Transport- und Montagewerkzeug (24) mit dem aufgenommenen Bauteil zwischen einer Bauteilaufnahmeposition (30) und einer Bauteilablageposition (34) die Mess-Station (26) automatisch überfährt.

2. Vorrichtung nach Anspruch 1,
**dadurch gekennzeichnet,**
**dass** die Mess-Station (26) auf einem zweiten Schlitten (58) angeordnet ist, wobei der zweite Schlitten (58) quer zur Bewegungsrichtung (y-Achse) der Bauteiltransporteinheit (14) bewegbar ist.

3. Vorrichtung nach Anspruch 1,
**dadurch gekennzeichnet,**
**dass** die Mess-Station (26) verfahrbar auf dem ersten Schlitten (20) der Bauteiltransporteinheit (14) angeordnet ist.

4. Vorrichtung nach einem der vorhergehenden Ansprüche,
**dadurch gekennzeichnet,**
**dass** die Mess-Station (26) mindestens ein optisches Meßsystem aufweist.

5. Vorrichtung nach Anspruch 4,
**dadurch gekennzeichnet,**
**dass** das optische Meßsystem mindestens einen Sensorkopf (28) zur Bildaufnahme, mindestens eine Beleuchtungsquelle (40) mit einem daran angeschlossenen Lichtleiter (38) zur kurzzeitigen Bauteilbeleuchtung und mindestens eine Datenverarbeitungsanlage zur digitalen Bildauswertung und Bestimmung der Relativlage des Bauteils aufweist.

6. Vorrichtung nach Anspruch 5,
**dadurch gekennzeichnet,**
**dass** die Beleuchtungsquelle (40) ein Hochgeschwindigkeitsstroboskop ist.

7. Vorrichtung nach Anspruch 5 oder 6,
**dadurch gekennzeichnet,**
**dass** der Sensorkopf (28) aus einer CCD - Kamera (50), einer telezentrischen Makrooptik (46), einem Strahlteilerspiegel (44) zur 90°-Umlenkung des optischen Strahlengangs sowie zur koaxialen Einspiegelung der vom Stroboskop (40) erzeugten Beleuchtung und einem Einstellschlitten (48) zur Adaption des Fokus der CCD-Kamera (50) besteht.

8. Verfahren zur Montage von Bauteilen, insbesondere mit einer vollautomatischen Montagevorrichtung zur Herstellung mikrosystemtechnischer Produkte, wobei das Verfahren folgende Schritte umfasst:
a) Aufnahme von mindestens einem zu transportierenden und montierenden Bauteils mittels eines an einem ersten Schlitten (20) angeordneten Montagekopf (22) mit mindestens einem Transport- und Montagewerkzeug (24), wobei der erste Schlitten (20) quer zur Bewegungsrichtung (y-Achse) eines Materialtransportsystems (16) verfahrbar ist und an einer parallel zur Bewegungsrichtung (x-Achse) des Materialtransportsystems (16) bewegbaren Bauteiltransporteinheit (14) angeordnet ist;
b) Verfahren des Transport- und Montagewerkzeugs (24) mit dem Bauteil zu einer vorbestimmten Ablage- bzw. Bearbeitungsposition (34), wobei ein automatisches Überfahren einer Mess-Station (26) zur Bestimmung der Relativlage des von dem Transport- und Montagewerkzeug (24) aufgenommenen Bauteils zum Transport- und Montagewerkzeug (24) erfolgt und die Mess-Station (26) parallel zur Bewegungsrichtung (x-Achse) der Bauteiltransporteinheit (14) verfahrbar ausgebildet ist, wobei die Mess-Station (26) stationär oder verfahrbar an der Bauteiltransporteinheit (14) angeordnet ist;
c) Erzeugen eines Triggersignals in Abhängigkeit von einer y - Position des ersten Schlittens (20) und Aktivierung der Mess-Station (26) mittels des Triggersignals;
d) Übermittlung der durch die Mess-Station (26) ermittelten Positionsdaten an eine Datenverarbeitungsanlage und Berechnung der Relativlage des Bauteils zum Transport- und Montagewerkzeug (24).

9. Verfahren nach Anspruch 8,
**dadurch gekennzeichnet,**
**dass** die Mess-Station (26) ein optisches Meßsystem mit mindestens einem Sensorkopf (28) zur Bildaufnahme, mit mindestens einer Beleuchtungsquelle (40) mit einem daran angeschlossenen Lichtleiter (38) zur kurzzeitigen Bauteilbeleuchtung ist.

10. Verfahren nach Anspruch 9,
**dadurch gekennzeichnet,**
**dass** die Beleuchtungsquelle (40) ein Hochgeschwindigkeitsstroboskop ist.

11. Verfahren nach Anspruch 9 oder 10,
**dadurch gekennzeichnet,**
**dass** der Sensorkopf (28) aus einer CCD - Kamera (50), einer telezentrischen Makrooptik (46), einem Strahlteilerspiegel (44) zur 90°-Umlenkung des optischen Strahlengangs sowie zur koaxialen Einspiegelung der vom Stroboskop (40) erzeugten Beleuchtung und einem Einstellschlitten (48) zur Adaption des Fokus der Kamera (50) besteht.

12. Verfahren nach einem der Ansprüche 9 bis 11,
**dadurch gekennzeichnet,**
**dass** im Verfahrensschritt c) folgende Zwischenschritte ausgeführt werden:
c1) Weiterleiten des Triggersignal an das Hochgeschwindigkeitsstroboskop (40) und Auslösen eines Lichtblitzes von wenigen Mikrosekunden;
c2) Einkoppeln des Lichtblitzes über den Lichtleiter (38) in den Sensorkopf (28), wobei das Licht um 90 Grad umgelenkt und senkrecht auf die Bauteilunterseite projiziert wird;
c3) Gleichzeitige Aktivierung der CCD-Kamera (50) durch das Triggersignal, so dass eine Belichtung eines CCD-Sensors der CCD-Kamera (50) zeitsynchronisiert zum Lichtblitz erfolgt.

13. Verfahren nach einem der Ansprüche 9 bis 12,
**dadurch gekennzeichnet,**
**dass** eine zeitgleiche Messung der Position des mit dem Bauteil zu bestückenden Produktes erfolgt, wobei die im Verfahrensschritt d) berechnete Relativlage des Bauteils zum Transport- und Montagewerkzeug (24) mit der ermittelten Position des Produkts bzw. einer Ablageposition (34) auf dem Produkt verglichen und gegebenenfalls korrigiert wird, so dass eine lagegenaue Ablage des Bauteils auf dem Produkt erfolgt.

14. Verfahren nach einem der Ansprüche 9 bis 13,
**dadurch gekennzeichnet,**
**dass** die absolute Position des zu bestückenden Produkts bzw. die Ablageposition (34) des Bauteils mittels einer in dem Transport- und Montagewerkzeug (24) angeordneten optischen Mess-Station ermittelt wird.

## Claims

1. Apparatus for mounting components, especially a fully-automatic mounting apparatus for manufacturing micro-system-technical products as well as for mounting tasks in the semiconductor industry, including a mounting table (12), at least one material transporting system (16) for transporting the products to be loaded with components, at least one component transporting unit (14) disposed on the mounting table (12) and movable parallel to the direction of movement (x axis) of the material transporting system (16), and at least one mounting head (22) with at least one transporting and mounting tool (24), wherein the mounting head (22) is disposed on a first slide (20) of the component transporting unit (14), mobile and movable transversely to the direction of movement (y axis) of the component transporting unit (14), and a measuring station (26) for determining the relative position of a component received by the transporting and mounting tool (24) with respect to the transporting and mounting tool (24), wherein
the measuring station (26) is formed movably parallel to the direction of movement (x axis) of the component transporting unit (14), wherein the measuring station (26) is disposed stationarily or movably on the component transporting unit (14) such that the transporting and mounting tool (24) with the received component automatically passes the measuring station (26) between a component receiving position (30) and a component deposition position (34).

2. Apparatus according to claim 1,
**characterized in that**
the measuring station (26) is disposed on a second slide (58), wherein the second slide (58) is movable transversely to the direction of movement (y axis) of the component transporting unit (14).

3. Apparatus according to claim 1,
**characterized in that**
the measuring station (26) is disposed movably on the first slide (20) of the component transporting unit (14).

4. Apparatus according to any one of the preceding claims,
**characterized in that**
the measuring station (26) has at least one optical measuring system.

5. Apparatus according to claim 4,
**characterized in that**
the optical measuring system has at least one sensor head (28) for image pick-up, at least one illumination source (40) having a light guide (38) connected thereto for short-time component illumination, and at least one data processing system for digital image evaluation and determining the relative position of the component.

6. Apparatus according to claim 5,
**characterized in that**
the illumination source (40) is a high-speed stroboscope.

7. Apparatus according to claim 5 or 6,
**characterized in that**
the sensor head (28) is comprised of a CCD camera (50), telecentric macro-optics (46), a beam splitter mirror (44) for 90° deflection of the optical beam path as well as for coaxially mirroring the illumination generated by the stroboscope (40), and an adjusting slide (48) for adapting the focus of the CCD camera (50).

8. Method for mounting components, especially with a fully-automatic mounting apparatus for manufacturing micro-system-technical products, the method comprising the steps of:
a) receiving at least one component to be transported and mounted by means of a mounting head (22) disposed on a first slide (20), including at least one transporting and mounting tool (24), wherein the first slide (20) is movable transversely to the direction of movement (y axis) of a material transporting system (16) and disposed on a component transporting unit (14) movable parallel to the direction of movement (x axis) of the material transporting system (16);
b) moving the transporting and mounting tool (24) with the component to a predetermined deposition or processing position (34), respectively, wherein automatically passing a measuring station (26) for determining the relative position of the component received by the transporting and mounting tool (24) with respect to the transporting and mounting tool (24) is effected, and the measuring station (26) is formed movably parallel to the direction of movement (x axis) of the component transporting unit (14), wherein the measuring station (26) is disposed stationarily or movably on the component transporting unit (14);
c) generating a trigger signal depending on a y position of the first slide (20), and activating the measuring station (26) by means of the trigger signal;
d) transmitting the position data determined by the measuring station (26) to a data processing system, and calculating the relative position of the component with respect to the transporting and mounting tool (24).

9. Method according to claim 8,
**characterized in that**
the measuring station (26) is an optical measuring system having at least one sensor head (28) for image pick-up, including at least one illumination source (40) with a light guide (38) connected thereto for short-time component illumination.

10. Method according to claim 9,
**characterized in that**
the illumination source (40) is a high-speed stroboscope.

11. Method according to claim 9 or 10,
**characterized in that**
the sensor head (28) is comprised of a CCD camera (50), telecentric macro-optics (46), a beam splitter mirror (44) for 90° deviation of the optical beam path as well as for coaxially mirroring the illumination generated by the stroboscope (40), and an adjusting slide (48) for adapting the focus of the camera (50).

12. Method according to any one of claims 9 to 11,
**characterized in that**
in method step c) the following intermediate steps are carried out:
c1) passing the trigger signal to the high-speed stroboscope (40) and initiating a flash of light of a few microseconds;
c2) coupling-in the flash of light via the light guide (38) into the sensor head (28), wherein the light is deviated by 90 degrees and is projected perpendicularly to the component bottom side;
c3) simultaneously activating the CCD camera (50) by the trigger signal such that exposure of a CCD sensor of the CCD camera (50) is effected time-synchronized with the flash of light.

13. Method according to any one of claims 9 to 12,
**characterized in that**
a simultaneous measurement of the position of the product to be loaded with the component is effected, wherein the relative position of the component with respect to the transporting and mounting tool (24) calculated in method step d) is compared to the determined position of the product or a deposition position (34) on the product, respectively, and optionally corrected such that positionally accurate deposition of the component on the product is effected.

14. Method according to any one of claims 9 to 13,
**characterized in that**
the absolute position of the product to be loaded or the deposition position (34) of the component, respectively, is determined by means of an optical measuring station disposed in the transporting and mounting tool (24).

## Revendications

1. Dispositif de montage de pièces, en particulier dispositif de montage entièrement automatique pour la fabrication de produits de la technique des microsystèmes ainsi que pour des tâches de montage de l'industrie des semi-conducteurs, comportant une table de montage (12), au moins un système de transport de matériel (16) pour le transport des produits à équiper de pièces, au moins une unité de transport de pièces (14) disposée sur la table de montage (12) et mobile parallèlement à la direction de déplacement (axe x) du système de transport de matériel (16) et au moins une tête de montage (22) comportant au moins un outil de transport et de montage (24), la tête de montage (22) étant disposée en un premier chariot (20) de l'unité de transport de pièces (14), mobile et déplaçable transversalement à la direction de déplacement (axe y) de l'unité de transport de pièces (14) et une station de mesure (26) pour déterminer la position relative d'une pièce reprise par l'outil de transport et de montage (24) par rapport à l'outil de transport et de montage (24),
la station de mesure (26) étant constituée de façon à être déplaçable parallèlement à la direction de déplacement (axe x) de l'unité de transport de pièces (14), la station de mesure (26) étant disposée de façon stationnaire ou déplaçable à l'unité de transport de pièces (14), de manière telle que l'outil de transport et de montage (24) passe automatiquement au dessus de la station de mesure (26) avec la pièce reprise entre une position de reprise de pièce (30) et une position de dépôt de pièce (34).

2. Dispositif selon la revendication 1,
**caractérisé en ce que**
la station de mesure (26) est disposée sur un deuxième chariot (58), le deuxième chariot (58) étant mobile transversalement à la direction de déplacement (axe y) de l'unité de transport de pièces (14).

3. Dispositif selon la revendication 1,
**caractérisé en ce que**
la station de mesure (26) est disposée sur le premier chariot (20) de l'unité de transport de pièces (14) de façon à être déplaçable.

4. Dispositif selon l'une quelconque des revendications précédentes,
**caractérisé en ce que**
la station de mesure (26) présente au moins un système optique de mesure.

5. Dispositif selon la revendication 4,
**caractérisé en ce que**
le système optique de mesure présente au moins une tête de capteur (28) pour la prise d'image, au moins une source d'illumination (40) à laquelle un conducteur de lumière (38) est raccordé pour l'illumination brève de la pièce et au moins une installation de traitement de données pour l'exploitation numérique d'image et la détermination de la position relative de la pièce.

6. Dispositif selon la revendication 5,
**caractérisé en ce que**
la source d'illumination (40) est un stroboscope à haute vitesse.

7. Dispositif selon la revendication 5 ou 6,
**caractérisé en ce que**
la tête de capteur (28) se constitue d'une caméra CCD (50), une optique macro télécentrique (46), un miroir séparateur (44) pour dévier de 90 ° le faisceau optique ainsi que pour l'ajout coaxial par reflet de l'illumination produite par le stroboscope et un chariot de réglage (48) pour l'adaptation de la focale de la caméra CCD (50).

8. Procédé de montage de pièces, en particulier avec un dispositif de montage entièrement automatique pour la fabrication de produits de la technique des microsystèmes, le procédé comprenant les étapes suivantes
a) réception d'au moins une pièce à transporter et à monter d'au moins une tête de montage (22) disposée en un premier chariot (20) avec au moins un outil de transport et de montage (24), le premier chariot (20) étant déplaçable transversalement à la direction de déplacement (axe y) d'un système de transport de matériel (16) et disposé en une unité de transport de pièces (14) mobile parallèlement à la direction de déplacement (axe x) du système de transport de matériel (16) ;
b) déplacement de l'outil de transport et de montage (24) avec la pièce vers une position prédéfinie de dépôt ou de traitement (34), un passage automatique s'effectuant au-dessus d'une station de mesure (26) pour déterminer la position relative de la pièce reprise par l'outil de transport et de montage (24) par rapport à l'outil de transport et de montage (24) et la station de mesure (26) étant constituée de façon à être déplaçable parallèlement à la direction de déplacement (axe x) de l'unité de transport de pièces (14), la station de mesure (26) étant disposée à l'unité de transport de pièces (14) de façon stationnaire ou déplaçable ;
c) génération d'un signal de déclenchement en fonction d'une position y du premier chariot (20) et activation de la station de mesure (26) au moyen du signal de déclenchement ;
d) transmission des données de position déterminées par la station de mesure (26) à une installation de traitement de données et calcul de la position relative de la pièce par rapport à l'outil de transport et de montage (24).

9. Procédé selon la revendication 8,
**caractérisé en ce que**
la station de mesure (26) est un système optique de mesure présentant au moins une tête de capteur (28) pour la prise d'image, avec au moins une source d'illumination (40) à laquelle un conducteur de lumière (38) est raccordé pour l'illumination brève de la pièce.

10. Procédé selon la revendication 9,
**caractérisé en ce que**
la source d'illumination (40) est un stroboscope à haute vitesse.

11. Procédé selon la revendication 9 ou 10,
**caractérisé en ce que**
la tête de capteur (28) se constitue d'une caméra CCD (50), une optique macro télécentrique (46), un miroir séparateur (44) pour dévier de 90 ° le faisceau optique ainsi que pour l'ajout coaxial par reflet de l'illumination produite par le stroboscope et un chariot de réglage (48) pour l'adaptation de la focale de la caméra CCD (50).

12. Procédé selon l'une quelconque des revendications 9 à 11,
**caractérisé en ce que**
dans l'étape c), les étapes intermédiaires suivantes sont exécutées :
c1) transmission du signal de déclenchement au stroboscope haute vitesse (40) et déclenchement d'un éclair lumineux de quelques microsecondes ;
c2) introduction de l'éclair lumineux par le conducteur de lumière (38) dans la tête de capteur (28), la lumière étant déviée de 90 ° et projetée perpendiculairement sur la face inférieure de pièce ;
c3) activation simultanée de la caméra CCD (50) par le signal de déclenchement, si bien qu'une exposition d'un capteur CCD de la caméra CCD (50) s'effectue en synchronisation avec l'éclair lumineux.

13. Procédé selon l'une quelconque des revendications 9 à 12,
**caractérisé en ce que**
une mesure simultanée de la position du produit à équiper de la pièce se réalise, la position relative calculée à l'étape d) de la pièce par rapport à l'outil de transport et de montage (24) étant comparée avec la position déterminée du produit ou une position de dépôt (34) sur le produit et éventuellement corrigée, si bien qu'un dépôt en position précise de la pièce sur le produit s'effectue.

14. Procédé selon l'une quelconque des revendications 9 à 13,
**caractérisé en ce que**
la position absolue du produit à équiper ou la position de dépôt (34) de la pièce est déterminée au moyen d'une station optique de mesure disposée dans l'outil de transport et de montage (24).
